# EUROPEAN PATENT SPECIFICATION

(11) **EP 4 480 899 B1**
(45) Date of publication and mention of the grant of the patent: **18.02.2026**
(21) Application number: 24180148.9
(22) Date of filing: 05.06.2024
(51) Int. Cl.: B81B 7/02, G01P 5/00, G01P 15/08, G01P 15/09, B81B 7/00

(54) **INERTIAL MEMS DEVICE INTEGRATING A WAKE-UP ELEMENT, INERTIAL MEMS SYSTEM AND MANUFACTURING METHOD**
TRÄGHEITS-MEMS-VORRICHTUNG MIT EINEM AUFWECKELEMENT, TRÄGHEITS-MEMS-SYSTEM UND HERSTELLUNGSVERFAHREN
DISPOSITIF MEMS INERTIEL INTÉGRANT UN ÉLÉMENT DE RÉVEIL, SYSTÈME MEMS INERTIEL ET PROCÉDÉ DE FABRICATION

(30) Priority: 23.06.2023 IT 202300013002
(43) Date of publication of application: 25.12.2024
(73) Proprietor: STMicroelectronics International N.V., 1228 Plan-les-Ouates, Geneva (CH)
(72) Inventor: SEGHIZZI, Luca, 20125 Milano (IT); VERCESI, Federico, 20134 Milano (IT); LONGONI, Gianluca, 20063 Cernusco sul Naviglio (MI) (IT); NOMELLINI, Andrea, 20159 Milano (IT)
(74) Representative: Studio Torta S.p.A.

(56) References cited:
- US-A1- 2022 073 342
- US-B2- 8 220 330
- STOECKEL CHRIS ET AL: "Wake up MEMS for inertial sensors", 2015 IEEE INTERNATIONAL SYMPOSIUM ON INERTIAL SENSORS AND SYSTEMS (ISISS) PROCEEDINGS, IEEE, 23 March 2015 (2015-03-23), pages 1 - 4, XP032775528, DOI: 10.1109/ISISS.2015.7102385

## Description

### Technical Field

The present invention relates to an inertial micro-electro-mechanical (MEMS) device integrating a wake-up element, an inertial MEMS system and a manufacturing method.

In particular, the considered inertial MEMS device comprises one or more inertial sensors, such as an accelerometer and/or a gyroscope, formed in at least one silicon structural layer and defining at least one movable structure. The movable structure generally has a main extension in an extension plane and is movable in-plane or out-of-plane.

### Background

As known, inertial MEMS devices of this type are increasingly being used in consumer, automotive and industrial applications, often integrate two or more inertial sensors in a same die and are packaged together with the related control circuits, generally formed in a separate die and forming an ASIC (Application Specific Integrated Circuit), hereinafter also referred to as control unit.

In many applications, it is often desired that the inertial MEMS device is always on active as to be capable of real-time sensing movements and/or variations in the surrounding environment.

To this end, generally, the control circuits are always on. When the system is at rest, the control unit keeps the inertial MEMS device on in a low-consumption condition (low working frequency) so that it may sense environmental changes and generate interrupt signals; upon receiving the interrupt signals, the control unit activates the normal (high-frequency and high-consumption) operation of the system.

As a result, even in rest conditions of the system, the inertial MEMS device is kept active (or "awake"), even if at low frequency, and has a non-negligible consumption. However, this is unwanted since it prevents or at least limits the use of such systems in applications and conditions in which low consumption and/or long duration is required, without having an external power source.

To overcome this issue, it has already been proposed to provide an activation or "wake-up" structure arranged alongside the inertial MEMS device, integrated in the same die or in a suitable adjacent die. In rest condition, the inertial MEMS device is off and does not consume. When an environmental change occurs, the activation structure senses it and sends a signal to the control unit which activates the inertial MEMS device.

However, this arrangement increases the size of the overall device. Furthermore, sometimes, the total energy consumption is still too high compared to what desired in some applications.

STOECKEL CHRIS ET AL: "Wake up MEMS for inertial sensors", 2015 IEEE International Symposium on Inertial Sensors and Systems (ISISS) Proceedings, IEEE, 23 March 2015, p. 1-4, XP032775528 discloses a piezoelectric MEMS, wherein a piezoelectric film is arranged on the spring of a spring-mass system where this is used as a wake-up sensor to detect acceleration with low accuracy so that it may switch on a more sensitive inertial sensor for precise inertial measurement but only when this is actually needed. Since the main device is mostly in sleeping mode no current flows so its lifetime is extended.

US 8,220,330 discloses a vertically integrated MEMS sensor device having two separated sensor portions vertically coupled together. The two sensors are formed separately, utilizing different micromachining techniques and are subsequently coupled utilizing a wafer bonding technique.

US 2022/0073342 discloses a MEMS acoustic sensor comprising a cantilever structure including a diaphragm film that vibrates when receiving an external vibration and causes vibration of a diaphragm and detection of a solid conduction, a vibration or a sound pressure. A wake-up sensor may also be included to switch the device on when it detects a threshold acoustic signal.

The aim of the present invention is to provide a solution which overcomes the drawbacks of the prior art.

### Summary

According to the present invention, an inertial MEMS system, a method for the use of this inertial MEMS system and a manufacturing process are provided, as defined in the attached claims.

### Brief Description of the Drawings

For a better understanding of the present invention, some embodiments thereof are now described, purely by way of non-limiting example, with reference to the attached drawings, wherein:
- Figure 1 shows a block diagram of an inertial MEMS system including an inertial MEMS device;
- Figure 2 is a schematic top-view of an inertial MEMS system to which the invention applies;
- Figure 3 is a flow diagram relating to a possible work mode of the present inertial MEMS system;
- Figures 4A and 4B are cross-sections, taken along section lines A-A and B-B, respectively, of Figure 5, of the present inertial MEMS device;
- Figure 5 is a top-plan view of a possible layout of the inertial MEMS device of Figures 4A and 4B;
- Figure 6 is a top-plan view of a different possible layout of the inertial MEMS device of Figure 4;
- Figures 7A-15A are cross-sections, similar to Figure 4A, through a semiconductor wafer in successive manufacturing steps of the inertial MEMS device of Figure 5; and
- Figures 7B-15B are cross-sections, similar to Figure 4B, through the semiconductor wafer of Figures 7A-15A, in successive manufacturing steps of the inertial MEMS device of Figure 5, wherein Figures 7A-15A and 7B-15B having the same figure number (7-15) relate to a same manufacturing step.

### Description of Embodiments

The following description refers to the arrangement shown; consequently, expressions such as "above", "below", "upper", "lower", "right", "left" relate to the accompanying figures and should not be interpreted in a limiting manner.

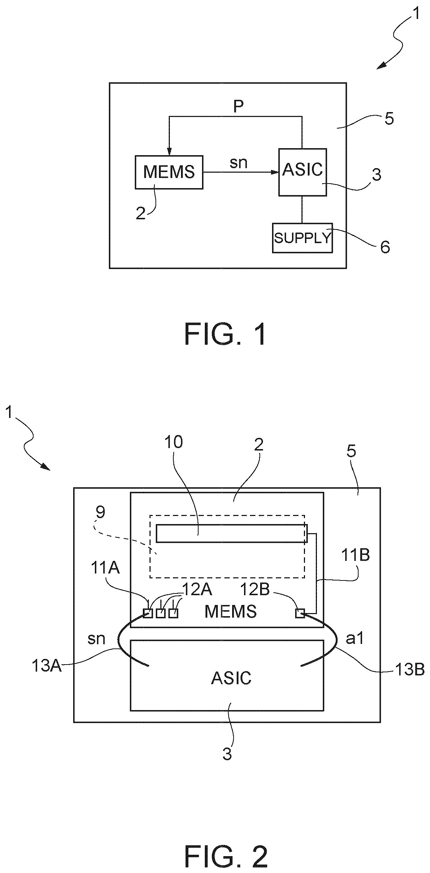

Figure 1 shows an inertial MEMS system 1 comprising an inertial MEMS device 2 and a control unit 3, implemented as an ASIC (Application Specific Integrated Circuit) and including control circuits for the inertial MEMS device 2.

The inertial MEMS system 1 is for example packaged in a housing 5 and further comprises a supply unit 6, for example a rechargeable battery, which may be enclosed in the housing 5 or be external.

The control unit 3 receives signals sn, typically movement signals, from the inertial MEMS device 2 and sends electrical supply and control quantities (for example a voltage P) to the inertial MEMS device 2.

The inertial MEMS device 2 incorporates a wake-up element 10, as shown in Figure 2.

In detail, with reference to Figure 2, the inertial MEMS device 2 here comprises a movable mass 9 and the wake-up element, indicated by 10 and overlying the movable mass 9.

The inertial MEMS device 2 is electrically coupled to the control unit 3, for example through first conductive tracks 11A, first contact pads 12A and first wires 13A, in a per se known manner, for exchanging electrical quantities (power supply, movement signals sn).

The wake-up element 10, as discussed in detail below, is formed here by a suspended structure, such as a membrane or cantilever, carrying a piezoelectric structure.

The piezoelectric structure is electrically coupled to the control unit 3, for example through one or more second conductive tracks 11B, one or more second contact pads 12B and one or more second wires 13B, and provides awakening signals, here awakening signal a1.

The wake-up element 10, being a piezoelectric structure arranged on a membrane or cantilever, does not require power supply and is able of generating an output current if subject to shocks, accelerations or other movements; this current may be sensed and cause the activation of the inertial MEMS system 1.

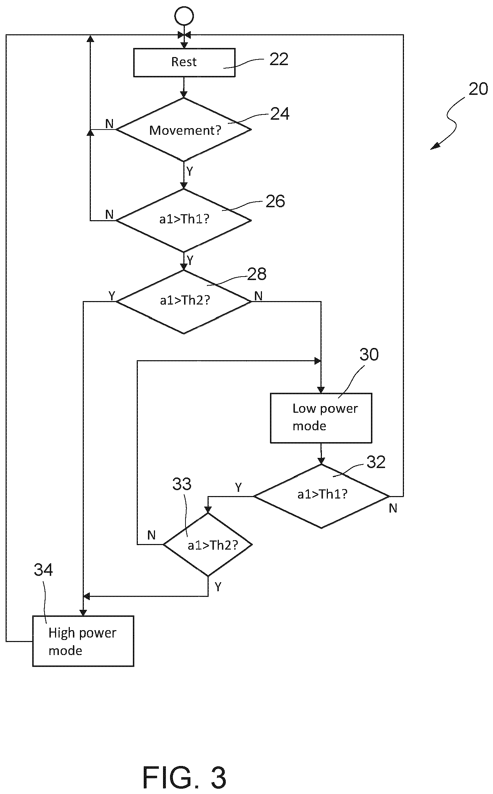

In particular, activation may occur according to two activation modes, depending on the extent of the environmental change sensed, as shown in the flow diagram 20 of Figure 3.

In detail, in absence of environmental changes, the inertial MEMS system 1 is in rest condition, block 22. In this condition, the inertial MEMS device 2 is off, it receives no power supply and the control unit 3 operates in a minimum activity condition, with very low consumption. For example, in this condition, the inertial MEMS system 1 may consume a current of a few nA (nanoAmpere)/sec.

When the wake-up element 10 senses a movement, an acceleration or shock, output Y from block 24, it generates an awakening signal a1. The awakening signal a1 (for example, a continuous signal) is provided by the wake-up element 10 to the control unit 3 which verifies its amplitude.

If the awakening signal a1 is lower than a first threshold Th1, output N from block 24, the inertial MEMS system 1 remains in the rest condition, returning to block 22.

If the awakening signal a1 exceeds the first threshold Th1, output Y from block 24, the control unit 3 awakes the inertial MEMS system 1, comprising the inertial MEMS device 2 and its own circuits intended for powering the inertial MEMS device 2 and for processing the signals sn provided by the latter.

In particular, if the awakening signal a1 is higher than the first threshold Th1, but lower than a second threshold Th2, higher than the first threshold Th1, output N from block 24, control unit 3 activates the inertial MEMS device 2 in low-power (low-frequency and low-consumption) mode, block 30. For example, in this condition, inertial MEMS device 2 may work with a sampling frequency of a few Hz (for example, 1.6 Hz), providing the relevant measured signal samples at such frequency. In this case, for example, the inertial MEMS system 1 may have a total consumption of the order of a few hundreds of nA (nanoAmpere)/sec.

In this working condition, the accuracy of the movement information provided by the inertial MEMS system 1 is not high, but may be sufficient for some low-requirement applications (low-power working condition).

Furthermore, in this working condition, the control unit 3 continues to monitor the awakening signal a1. If this remains lower than the first threshold Th1, output N from block 32, after some time the control unit 3 stops powering the inertial MEMS device 2 and returns to the rest condition of block 22.

Conversely, if the awakening signal a1 is higher than the first threshold Th1, output Y from block 32, it is verified whether the awakening signal a1 has become higher than the second threshold Th2, block 33. If not, output N from block 33, the inertial MEMS system 1 remains in the low-power mode, returning to block 30. If it becomes higher, output Y from block 33, the control unit 3 causes the inertial MEMS system 1 to work in the high-power (high-frequency, high-consumption) working mode, block 34.

Similarly, returning to block 28, if the awakening signal a1 is higher than the second threshold Th2, output Y from block 28, the control unit 3 activates the inertial MEMS device 2 so as to cause it to operate in high-power (high-frequency, high-consumption) mode, block 34.

For example, in the high-power mode, block 34, the inertial MEMS device 2 may work with a sampling frequency of more than 1500Hz, providing the relative signal samples sn to the control unit 3 at this frequency. In this case, for example, the inertial MEMS system 1 may have a total consumption of the order of a few tens of µA (microAmpere) /sec.

The inertial MEMS system 1 remains in the high-power working mode (block 34) as long as the awakening signal a1 provided by the wake-up element 10 remains higher than the second threshold Th2 and/or as long as the control unit 3 receives the movement signals sn (movement signals sn greater than the movement threshold). In this case, the control unit 3 stops powering the inertial MEMS device 2 and takes the inertial MEMS system 1 back to the rest condition, returning to block 22. Obviously, the control unit 3 may provide for more complex logics and verifications for activating the high-power operating mode, to take into account particular functions and/or specific applications.

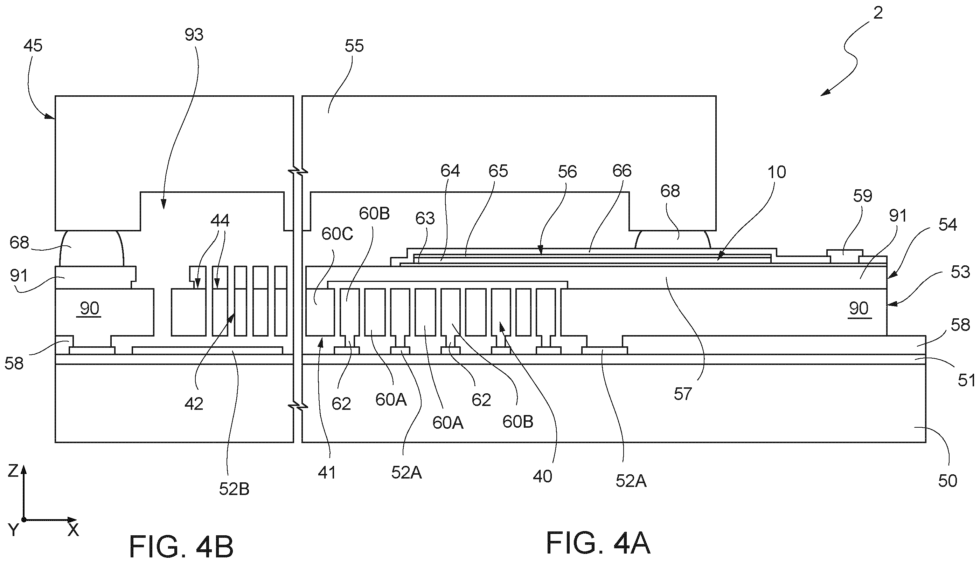

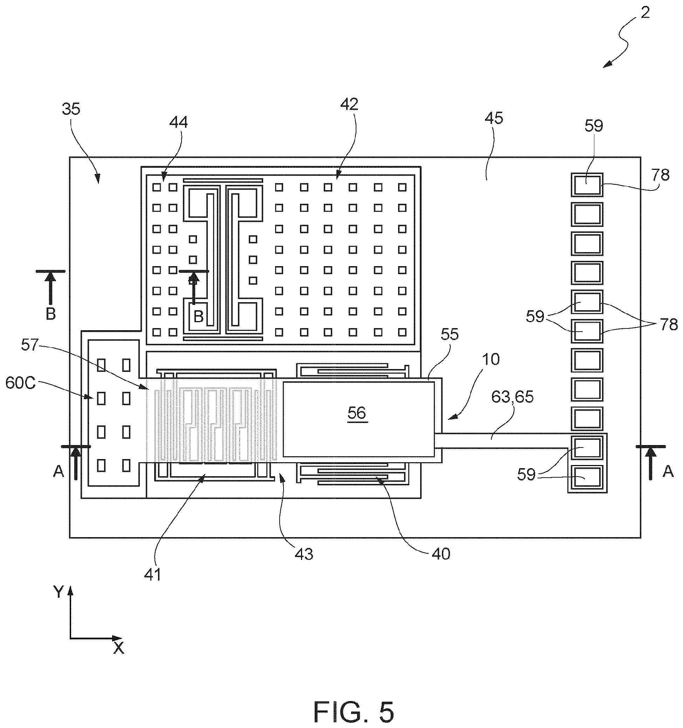

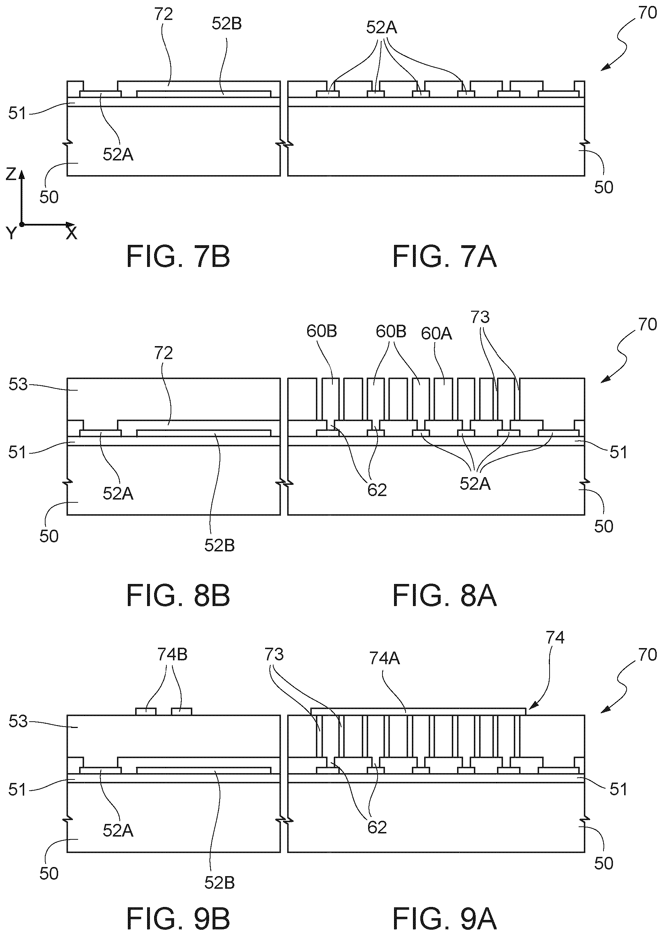

Figures 4A and 4B show a possible implementation of the inertial MEMS device 2 incorporating the wake-up element 10. It should be noted that, for a better understanding of the structure and the manufacturing process, Figures 4A and 4B (as well as the following Figures 7A-15A and 7B-15B) show side by side two distinct zones of the inertial MEMS device 2, as indicated by the arrows A-A and B-B of Figure 5.

In particular, Figures 4A and 4B refer to an inertial MEMS device 2 comprising an inertial sensor, here a triaxial accelerometer 35, of a capacitive type.

The triaxial accelerometer 35 comprises a first sensing portion 40, a second sensing portion 41 and a third sensing portion 42. The sensing portions 40-42 include movable structures having a substantially planar extension, parallel to a plane XY of a Cartesian reference system XYZ.

In particular, in Figures 4A and 4B, the first sensing portion 40 is intended for sensing oscillations along a first horizontal axis X of the Cartesian reference system XYZ; the second sensing portion 41 is intended for sensing oscillations along a second horizontal axis Y of the Cartesian reference system XYZ; and the third sensing portion 42 is intended for sensing oscillations along a vertical axis Z of the Cartesian reference system XYZ.

In detail, the inertial MEMS device 2 of Figures 4A, 4B is formed in a die 45 of semiconductor material, comprising a substrate 50, for example of monocrystalline silicon; an insulating layer 51, overlying the substrate 50, for example formed by a silicon oxide layer; conductive structures, for example of polycrystalline silicon, overlying the insulating layer 51 and forming conductive regions 52A (for example the conductive tracks 11A, 11B of Figure 2) and second fixed electrodes (here a lower electrode 52B of the third sensing portion 42 is visible); a first structural layer 53, for example of polycrystalline silicon, overlying the insulating layer 51 and the conductive structures 52A and 52B (to which it may be electrically connected, as for the conductive regions 52A, or be coupled capacitively, as for the lower electrode 52B); a second structural layer 54, for example of polycrystalline silicon, overlying the first structural layer 53 and mechanically and electrically coupled thereto in some zones; a piezoelectric stack 56, overlying the second structural layer 54; and a cap 55, for example of monocrystalline silicon, overlying and attached to the second structural layer 54.

In Figures 4A, 4B, the first structural layer 53 has a greater thickness than the second structural layer 54. For example, the first structural layer 53 may have a thickness comprised between 2 and 80 µm and the second structural layer 54 may have a differentiated thickness according to the zones and comprised between 1 and 2 µm. In general, the second structural layer 54 may have a widely variable thickness, according to the application, comprised between 0.5-1 µm and 80 µm.

Furthermore, the inertial MEMS device 2 of Figures 4A, 4B comprises dielectric regions 58, arranged between the insulating layer 51 and the first structural layer 53; electrical connection regions 59, for example of metal such as AlCu (aluminum-copper), arranged above the second structural layer 54 for forming electrical connections, for example of the contact pads 12A, 12B of Figures 4A, 4B; and bonding regions 68, of adhesive material, such as glassfrit, arranged between the cap 55 and the second structural layer 54.

In particular, the first structural layer 53 and the second structural layer 54 are patterned and locally thinned so as to define movable and fixed structures of the triaxial accelerometer (movable masses, electrodes, suspension springs) and to electrically separate the various portions of the die 45.

The inertial MEMS device 2 has therefore structures having at least three thicknesses, and precisely structures having a first thickness, equal to the thickness of the first structural layer 53, structures having a second thickness, equal to the sum of the thicknesses of the first and the second structural layers 53, 54; and structures having a third thickness, lower than the thickness of the second structural layer 54, due to a partial removal of the thickness of the second structural layer 54, as explained in detail below.

For example, in Figures 4A, 4B, the first and the second sensing portions 40, 41 have first movable electrodes 60A and first fixed electrodes 60B formed by only the first structural layer 53 and therefore have the first thickness; the third sensing portion 42 has the second movable mass 44 (forming second movable electrodes) formed, in the portion shown, by both structural layers 53, 54 and therefore has the second thickness; and a cantilever 57 extends above the first and the second sensing portions 40, 41 and is formed by the second structural layer 54, locally thinned, and therefore has the third thickness.

In Figures 4A, 4B part of a suspended mass 60C is also visible, integral with one end of the cantilever 57, formed by the first and the second structural layers 53, 54 and therefore having the first thickness. The suspended mass 60C is here arranged laterally to the second sensing portion 40, 41, as visible in Figure 5.

The piezoelectric stack 56 extends on the cantilever 57 and forms, with the latter, the wake-up element 10 of Figure 2. In a manner not shown, an insulating layer extends between the piezoelectric stack 56 and the cantilever 57, electrically insulating them.

The first fixed electrodes 60B are directly and electrically connected to respective conductive regions 52A through support and connection portions 62 and face respective first movable electrodes 60A.

In particular, the first movable electrodes 60A and the first fixed electrodes 60B face each other at facing surfaces extending in the thickness direction of the first structural layer 53 (perpendicularly to the extension plane XY of the movable structures of the sensing portions 40-42).

The second movable mass 44 overlies and capacitively coupled to the lower electrodes 52B, in a direction perpendicular to the extension plane of the triaxial accelerometer 35.

The cantilever 57 is suspended on the first structural layer 53 and more precisely, here, extends above the first and the second sensing portions 40, 41.

In particular, here, the cantilever 57 is supported at a first end (on the right in Figure 4A) rigid with fixed portions of the die 45 and has a second end (on the left in Figure 4A) integral with the suspended mass 60C. In this manner, the cantilever 57 has a high sensitivity.

The piezoelectric stack 56 comprises a lower electrode region 63, formed by a first conductive layer (single or multiple); a piezoelectric region 64, of piezoelectric material; and an upper electrode region 65, formed by a second conductive layer (single or multiple).

For example, the lower electrode region 63 may be formed by a platinum (Pt) layer overlying a titanium (Ti) layer, or may comprise molybdenum (Mo) and/or doped polycrystalline silicon; the piezoelectric region 64 may be formed by a piezoelectric material such as a PZT (based on lead and titanium zirconate, Pbₓ[Zr_{y}Ti_{1-y}]O₃), or may comprise an aluminum nitride (AlN) or scandium-doped aluminum nitride (AlScN) layer; and the upper electrode region 56 may be formed by a plurality of layers including indium tin oxide (ITO) and a tungsten-titanium (TiW) alloy or by a molybdenum (Mo) or aluminum-copper (AlCu) layer.

In particular, the piezoelectric stack 56 may comprise an aluminum nitride layer (lower layer) and a molybdenum layer (upper layer) for the lower electrode region 63 (in which case, an insulating layer below the piezoelectric stack 56 is not necessary); a crystalline aluminum nitride (AlN) layer for the piezoelectric region 64; and a molybdenum layer for the upper electrode region 65.

According to a variant, the piezoelectric region 64 may be formed by potassium sodium niobate (KNN), with lower and upper electrodes 63, 65 of platinum.

The layers forming the upper electrode region 64 may extend above the second structural layer 54, beyond the piezoelectric stack 56, to form the conductive track 11B of Figure 2 and be in direct electrical contact with one of the electrical connection regions 59.

A protection dielectric layer 66, for example of non-amorphous aluminum nitride (AlN), covers the piezoelectric stack 56 and is open at the electrical connection regions 59 for electrically connecting the lower electrode region 63 and the upper electrode region 65.

The cap 55 has (in top-view) a smaller area than the first and the second structural layers 53, 54 and is rigid with fixed portions formed by the first structural layer 53 (first fixed portions 90 rigid with to the substrate 50) and by the second structural layer 54 (second fixed portions 91 overlying and rigid with the first fixed portions 90).

The cap 55 is rigid with the second fixed portions 91 and forms, together with the substrate 50, the first and the second fixed portions 90, 91, a chamber 93 enclosing the inertial sensor (triaxial accelerometer) 35 and the wake-up element 10.

Here, the chamber 93 is closed; in this manner, the inertial sensor (triaxial accelerometer) 35 and the wake-up element 10 are contained in an environment closed to the outside and are protected from environmental damage, while being free to move for sensing movements of the inertial MEMS device 2. Furthermore, the wake-up element 10 is positioned in close proximity to the inertial sensor 35, thereabove, and therefore does not require additional space and has high sensitivity.

Furthermore, since the wake-up element 10 is positioned in close contact with the sensing portions 40-42, inside the chamber 93, it is not subject to damping due to the atmosphere.

A possible shape of the cantilever 57 is shown in Figure 5.

Here, the first and the second sensing portions 40, 41 (for sensing oscillations along the first horizontal axis X and, respectively, oscillations along the second horizontal axis Y) are arranged side by side, along the first horizontal axis X, and comprise a first movable structure 43 integral with the movable electrodes 60A.

The third sensing portion 42 (for sensing oscillations along the vertical axis Z) is here arranged side by side with the first and the second sensing portions 40, 41 along the second horizontal axis Y, and has a second movable mass 44, forming second movable electrodes.

The cantilever 57 has here a rectangular shape and extends above the first and the second sensing portions 40, 41.

In particular, in Figure 5, the cantilever 57 has a length (in the direction parallel to the first horizontal axis X) approximately equal to the sum of the lengths of the first and the second sensing portions 40, 41 along the same first horizontal axis X.

Furthermore, the cantilever 57 has a width (in the direction parallel to the second horizontal axis Y), lower than the size of the first sensing portion 40 (or of the second sensing portion 41) along the same second horizontal axis Y, even if this is not essential.

The piezoelectric stack 56 may extend only on the first sensing portion 40, as shown, or may extend along the entire cantilever 57.

As an alternative to what shown, the wake-up element 10 might be arranged only on the first or the second sensing portion 40, 41; furthermore, the inertial MEMS device 2 might have two wake-up elements 10, one for each sensing axis X, Y, for greater sensitivity, or one for each sensing portion 40, 41. Furthermore, the wake-up element 10 might also, or only, be formed on the third sensing portion 42.

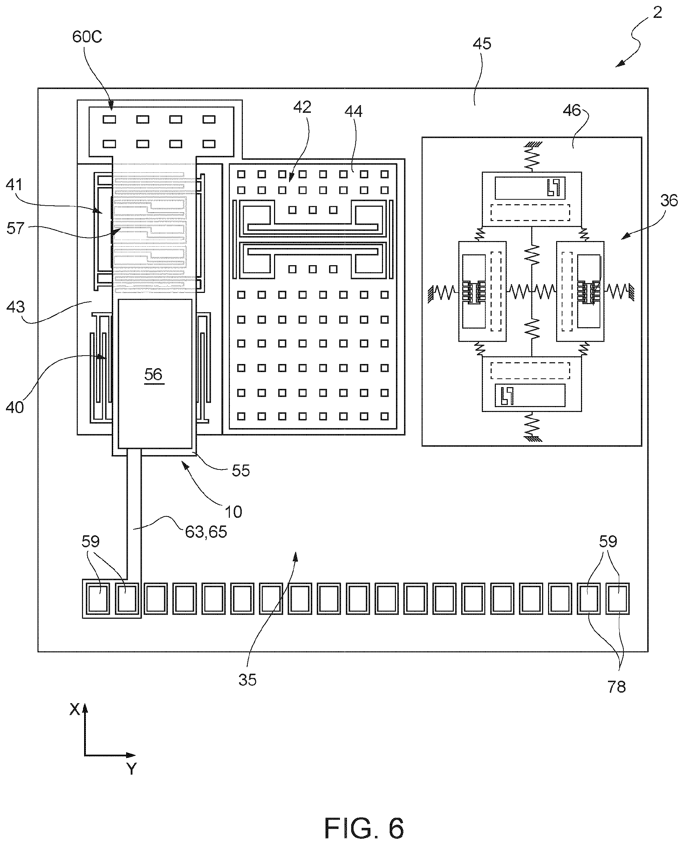

Figure 6 shows a different implementation of the inertial MEMS device 2. Here, the inertial MEMS device 2 comprises, in addition to the inertial sensor (triaxial accelerometer) 35, another inertial sensor, here a gyroscope 36.

Here, the gyroscope 36 is accommodated in the chamber 93 together with the triaxial accelerometer 35 and has a movable mass 46.

Also here, the wake-up element 10 extends above the first and the second sensing portions 40, 41, between a fixed portion of the die 45 and the suspended mass 60C, but it might extend on only one of the sensing portions 40, 41.

Furthermore, if the or part of the third sensing portion 42 and/or of the gyroscope 36 are formed only in the first structural layer 53, the wake-up element 10 might be (also or alternatively) formed over one or both of them, so as to have more wake-up elements 10 on two or more sensing portions 40-42 and/or on the gyroscope 36.

The inertial MEMS device 2 is completely off in rest condition.

When the inertial MEMS device 2 undergoes a shock or is moved, the cantilever 57, suspended, bends and/or is subject to vibrations, causing the piezoelectric stack 56 to deform. As a result, this generates a small current, provided to the control unit 3. As described above with reference to Figure 3, when the current exceeds the first threshold Th1, the control unit 3 senses it and may turn on the inertial MEMS system 1 in low- or high-power condition (depending on whether or not this current exceeds the first and the second thresholds Th1, Th2).

The inertial MEMS device 2 of Figures 4A, 4B may be formed as shown in Figures 7-15 and described hereinbelow. In these Figures, the layers and non-defined structures, where useful for understanding, are indicated with the same reference numerals as in Figures 4A, 4B.

In detail, Figures 7A, 7B show a sensor wafer 70 of semiconductor material comprising the substrate 50.

The insulating layer 51, for example thermally grown or deposited, has been formed on the substrate 50.

The conductive structures 52A, 52B have been formed on the insulating layer 51, for example by depositing a polycrystalline silicon layer and subsequent photolithographic definition.

A first sacrificial layer 72, for example of silicon oxide, has been deposited and patterned above the conductive structures 52A, 52B. The first sacrificial layer 72 has been selectively removed above the conductive structures 52A, for example where the support and connection portions 62 are to be grown as well as it is desired to grow any other anchoring and electrical and/or mechanical connection portions which connect the structures formed in the first structural layer 53 to the substrate 50.

Successively, Figures 8A, 8B, using an epitaxial growth process, the first structural layer 53 is grown on the sensor wafer 70. The first structural layer 53 then grows where the first sacrificial layer 72 has been selectively removed, forming the support and connection portions 62.

Still with reference to Figures 8A, 8B, the first structural layer 53 is etched, for example by dry etching, where it is desired to form the first and the second sensing portions 40, 41 and any parts of the third sensing portion 42 (where structures having the first thickness are intended to be formed). Thus, first trenches 73 are formed which extend completely through the first structural layer 53. The etching automatically stops on the first sacrificial layer 72 and leads to the definition of the first movable electrodes 60A and the first fixed electrodes 60B.

Then, Figures 9A, 9B, a second sacrificial layer 74, for example of TEOS (TetraEthylOrthoSilicate), is deposited for a thickness comprised, for example, between 0.1 µm and 5 µm. The second sacrificial layer 74 may partially fill the first trenches 73, although such filling is not important.

The second sacrificial layer 74 is then planarized and selectively removed. Sacrificial portions are thus formed where it is desired that the second structural layer 54 be separated from the first structural layer 53 and/or have a reduced thickness. In particular, in this step a first sacrificial region 74A, where it is desired to form the cantilever 57 of Figures 4A, 4B, as explained below, as well as second sacrificial regions 74B are formed.

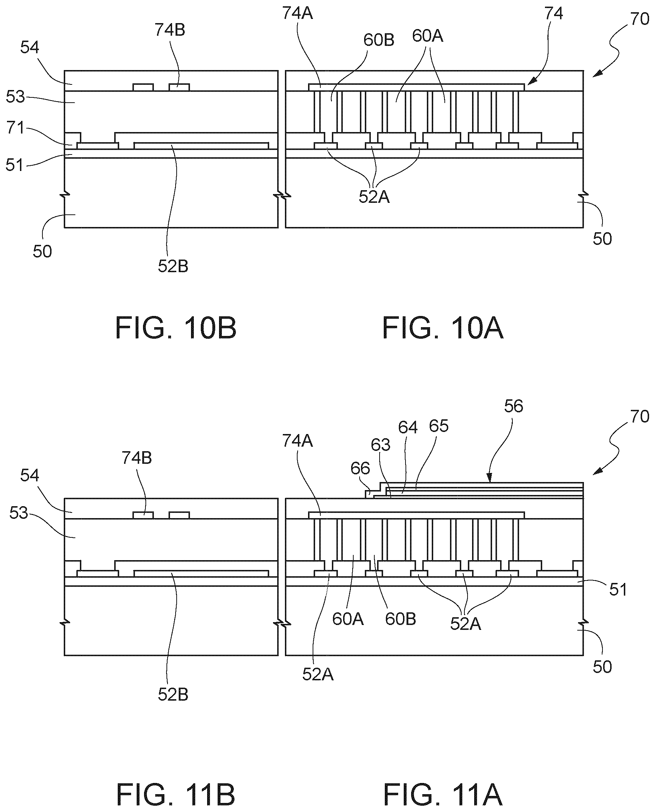

With reference to Figures 10A, 10B, the second structural layer 54 is grown above the first structural layer 53 and the second sacrificial layer 74. The second structural layer 54 is epitaxially grown and planarized, for example by CMP (Chemical Mechanical Polishing) so that, where no sacrificial regions 74A and 74B are present, a complete structural layer having the third thickness is formed. For example, here, the third thickness may be comprised between 1 and 2 µm.

Subsequently, Figures 11A, 11B, the piezoelectric stack 56 is formed, by depositing and patterning suitable layers to form the lower electrode region 63, the piezoelectric region 64, and the upper electrode region 65. Furthermore, the protection dielectric layer 66 is deposited and opened where it is desired to contact the electrode regions 63, 65.

Then, in a manner not shown, the electrical connection regions 59, for example of AlCu, are formed in electrical contact with the electrode regions 63, 65 (as regards the second contact pads 12B of Figure 2) and with corresponding underlying portions of the first and the second structural layers 53, 54 (as regards the first contact pads 12A of Figure 2).

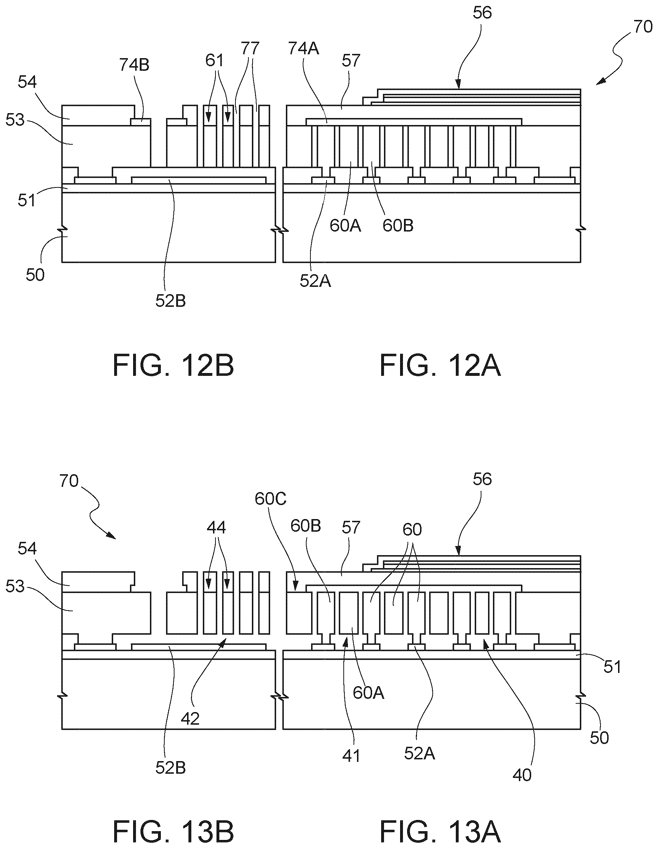

Subsequently, Figures 12A, 12B, the sensor wafer 70 is etched to define the structures formed by the sole second structural layer 54 or by both structural layers 53, 54, so as to separate them from the rest of the sensor wafer 70. In particular, here, using a mask not shown, the second structural layer 54 and the first structural layer 53 are dry etched.

In detail, in this step, the second movable mass 44 of the third sensitive zone 42 is defined and holes 77 are formed through the second movable mass 44. The second movable mass 44, in the part shown, therefore has the second thickness, equal to the sum of the thicknesses of the first and the second structural layers 53, 54.

Furthermore, in a manner not shown, the cantilever 57 as well as any other structures formed only in the second structural layer 54 are defined, where the first structural layer 53 is protected by the sacrificial regions 74A and 74B.

In this step, the trenches 78 (visible in Figure 5) are formed and delimit the portions of the complete structural layer 53, 54 below the electrical connection regions 59 (forming the first contact pads 12A) and in direct electrical contact with the conductive structures 52A and 52B through the conductive regions 52A.

The etching automatically stops on the first sacrificial layer 72.

Then, Figures 13A, 13B, the first and the second sacrificial layers 72, 74 are removed, where exposed, for example in hydrofluoric acid (HF), freeing the first movable electrodes 60A and the second movable mass 44.

Furthermore, the first movable electrodes 60A are separated from the respective fixed electrodes 60B and the second movable mass 44 is separated from the lower electrode 52B.

In this step, in particular, the sacrificial region 74A is removed, above the first sensing portion 40, freeing the cantilever 57.

Figures 13A, 13B show the sensing portions 40-42 completely defined and free.

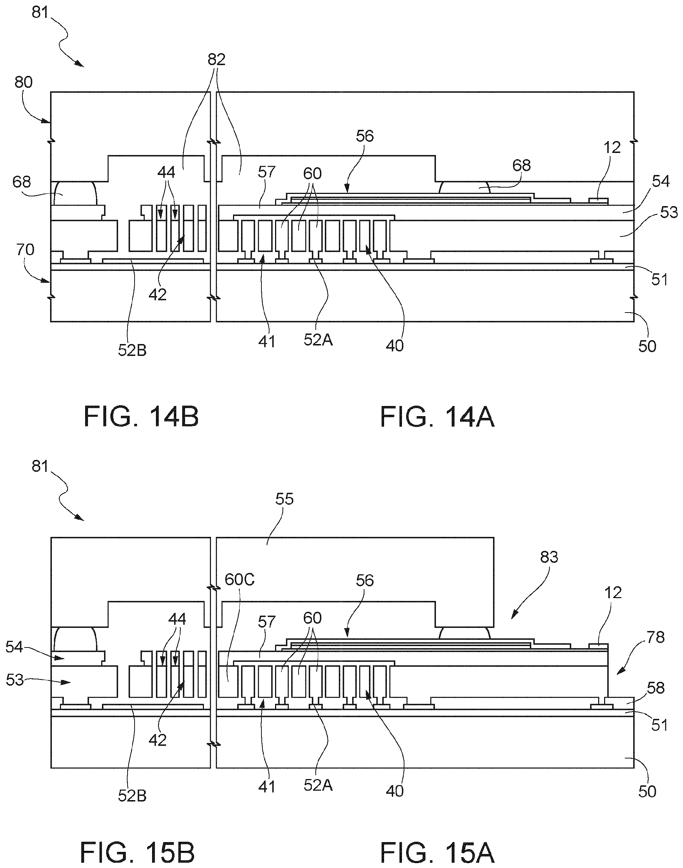

In Figures 14A, 14B a cap wafer 80 is attached to the sensor wafer 70 through the bonding regions 68, forming a composite wafer 81. It should be noted that Figures 14A, 14B show a wider area of the composite wafer 81 with respect to the sensor wafer 70 of Figures 7A-13, and specifically show the area of the contact pads 12 (on the right).

In these Figures, for the sake of simplicity, the first movable electrodes 60A and the first fixed electrodes 60B are generally indicated by 60.

The cap wafer 80 may have previously been worked to form recesses 82 above the sensing portions 40-42 and the wake-up element 10, allowing ample freedom of movement thereof.

The sensor wafer 70 may therefore be thinned, for example by CMP, so as to have a desired thickness in the direction of the vertical axis Z.

Then, Figures 15A, 15B, the cap wafer 80 is cut, for example by laser, to open a window 83 above the contact pads 12 (only one of the second contact pads 12B of Figure 2 is visible in Figure 15A,).

Then the overall wafer 81 is diced to form the inertial MEMS device 2 of Figures 4A, 4B and 5.

In this manner, the wake-up element 10 may be easily integrated into a manufacturing process of a MEMS inertial sensor, and therefore at a very low cost, by simply modifying the masks and forming the piezoelectric stack 56.

Furthermore, as discussed above, the wake-up element 10 requires no additional space compared to the inertial sensor(s) integrated in the inertial MEMS device 2 and this may be used even in units and apparatuses having very small dimensions.

In addition, the wake-up element 10 is protected from the external environment and has high sensitivity.

Finally, it is clear that modifications and variations may be made to the inertial MEMS device, the inertial MEMS system and the manufacturing process described and illustrated without thereby departing from the scope of the present invention, as defined in the attached claims.

For example, as indicated above, multiple cantilevers 57 may be present; the cantilevers may be arranged only on the first, the second or the third sensing portions 40, 41, 42. Multiple cantilevers may be provided on the same sensing portion 40-42 or on the gyroscope 36 and the cantilever may be of projecting type, attached and integral at only one end to fixed or movable parts; or may be supported at both ends.

## Claims

1. An inertial MEMS system (1) including an inertial MEMS device (2), comprising:
an inertial element (35; 36) responsive to movement, including a movable structure (43; 44; 46) formed in a first structural layer (53) of semiconductor material;
a suspended structure (57) extending above the movable structure, at a distance therefrom, the suspended structure (57) being formed in a second structural layer of semiconductor material; and
a piezoelectric structure (56) arranged on the suspended structure (57),
the suspended structure (57) and the piezoelectric structure (56) forming a wake-up element (10) configured to generate an activation signal (a1) in presence of vibrations or shocks
the system further comprising a control unit (3), the control unit (3) being electrically coupled to the inertial MEMS device (2) and comprising means configured to:
receive the activation signal (a1);
compare the activation signal (a1) with a first threshold (Th1) and a second threshold (Th2), greater than the first threshold,
activate the inertial MEMS device (2) with low-consumption operation if the activation signal (a1) is greater than the first threshold and smaller than the second threshold; and
activate the inertial MEMS device (2) with high-consumption operation if the activation signal (a1) is greater than the second threshold.

2. The inertial MEMS system according to claim 1, wherein the suspended structure (57) is a cantilever or a membrane.

3. The inertial MEMS system according to claim 1 or 2, further comprising a substrate (50) of semiconductor material, wherein the first structural layer (53) extends on the substrate and comprises first fixed portions (90) rigid with the substrate (50); the second structural layer (54) comprises second fixed portions (91) in direct contact with the first fixed portions (90); and a cap structure (55) is rigidly coupled to the second fixed portions (91) and forms, together with the substrate (50), the first fixed portions and the second fixed portions, a chamber (93) enclosing the inertial element (35; 36) and the wake-up element (10).

4. The inertial MEMS system according to any of the preceding claims, wherein the first and the second structural layers (53, 53) are of silicon.

5. The inertial MEMS system according to any of the preceding claims, wherein the piezoelectric structure (56) comprises a piezoelectric stack including a first electrode region (63), of a first conductive material, overlying the suspended structure (57); a piezoelectric region (64), of piezoelectric material, overlying the first electrode region (63); and a second electrode region (65), of a second conductive material, overlying the piezoelectric region (64); at least one of the first and the second electrode regions (63, 65) being coupled to external connection regions (12).

6. The inertial MEMS system according to any of the preceding claims, wherein the first structural layer (53) has a first thickness, the second structural layer (54) has a second thickness, smaller than the first thickness and the second structural layer (54) has a thin zone having a third thickness lower than the second thickness, the thin zone forming the suspended structure (57) and extending at a distance from the first structural layer (53).

7. The inertial MEMS system according to any of the preceding claims, wherein the inertial element (35, 36) forms an accelerometer and/or a gyroscope.

8. The inertial MEMS system according to any of the preceding claims, wherein the inertial element (35, 36) is of capacitive type.

9. The inertial MEMS system according to any of the previous claims, wherein the activation element further comprises a suspended mass (60C), integral to the suspended structure (57), formed by the first and second structural layers (53, 54) and arranged laterally to the inertial element (35; 36).
.

10. The inertial MEMS system according to any of the preceding claims, further comprising means configured to:
after the step of activating the inertial MEMS device (2) with low-consumption operation, receive electric measurement signals from the inertial element 35; 36; verify whether, after an acquisition time, the activation signal (a1) and/or the electric measurement signals are representative of predetermined movements; and, if the activation signal (a1) and/or the electric measurement signals are not representative of predetermined movements, deactivate the inertial MEMS device (2).

11. A method for activating an inertial MEMS device (2) in the inertial MEMS system according to any of claims 1-10, comprising:
receiving the activation signal (a1);
comparing the activation signal (a1) with a first threshold (Th1) and a second threshold (Th2), greater than the first threshold,
activating the inertial MEMS device (2) with low-consumption operation if the activation signal (a1) is greater than the first threshold and smaller than the second threshold; and
activating the inertial MEMS device (2) with high-consumption operation if the activation signal (a1) is greater than the second threshold.

12. A process for manufacturing an inertial MEMS system according to any of claims 1-10, comprising:
forming a first structural layer (53) of semiconductor material on a substrate (50);
forming an inertial element (35; 36), including a movable structure (43; 44; 46; 60A), in the first structural layer (53);
forming a second structural layer (54) of semiconductor material on the first structural layer (53);
forming a suspended structure (57) in the second structural layer (54), the suspended structure extending above the movable structure (43; 44; 46; 60A), at a distance therefrom; and
forming a piezoelectric structure above the suspended structure (57),
the suspended structure and the piezoelectric structure forming a wake-up element (10) configured to generate an activation signal (a1) in presence of vibrations or shocks.

13. The process according to the preceding claim, wherein forming a suspended structure (57) comprises:
before forming a second structural layer ((54)), forming a sacrificial region (72) above the movable structure (43; 44; 46; 60A);
after the step of forming a piezoelectric structure (56), defining the second structural layer (54); and removing the sacrificial region (72).

14. The process according to claim 12 or 13, further comprising attaching a cap structure (55) to the second structural layer (54) and forming, together with the substrate (50), the first structural layer (53) and the second structural layer (54), a chamber (93) enclosing the inertial element (35; 36) and the wake-up element (10).

## Patentansprüche

1. Trägheits-MEMS-System (1), das eine Trägheits-MEMS-Vorrichtung (2) enthält, die Folgendes umfasst:
ein Trägheitselement (35; 36), das auf Bewegung reagiert, das eine bewegliche Struktur (43; 44; 46) enthält, die in einer ersten Strukturschicht (53) aus Halbleitermaterial ausgebildet ist;
eine aufgehängte Struktur (57), die sich oberhalb der beweglichen Struktur in einem Abstand von dieser erstreckt, wobei die aufgehängte Struktur (57) in einer zweiten Strukturschicht aus Halbleitermaterial ausgebildet ist; und
eine piezoelektrische Struktur (56), die auf der aufgehängten Struktur (57) angeordnet ist,
wobei die aufgehängte Struktur (57) und die piezoelektrische Struktur (56) ein Wake-up-Element (10) bilden, das so konfiguriert ist, dass es bei Vorhandensein von Vibrationen oder Stößen ein Aktivierungssignal (a1) erzeugt,
wobei das System ferner eine Steuereinheit (3) umfasst, wobei die Steuereinheit (3) elektrisch mit der Trägheits-MEMS-Vorrichtung (2) gekoppelt ist und Mittel umfasst, die für Folgendes konfiguriert sind:
Empfangen des Aktivierungssignals (a1);
Vergleichen des Aktivierungssignals (a1) mit einem ersten Schwellenwert (Th1) und einem zweiten Schwellenwert (Th2), der größer als der erste Schwellenwert ist,
sAktivieren der Trägheits-MEMS-Vorrichtung (2) in dem verbrauchsarmen Betrieb, wenn das Aktivierungssignal (a1) größer als der erste Schwellenwert und kleiner als der zweite Schwellenwert ist; und
Aktivieren der Trägheits-MEMS-Vorrichtung (2) in dem verbrauchsintensiven Betrieb, wenn das Aktivierungssignal (a1) größer als der zweite Schwellenwert ist.

2. Trägheits-MEMS-System nach Anspruch 1, wobei die aufgehängte Struktur (57) ein Ausleger oder eine Membran ist.

3. Trägheits-MEMS-System nach Anspruch 1 oder 2, das ferner ein Substrat (50) aus Halbleitermaterial umfasst, wobei sich die erste Strukturschicht (53) auf dem Substrat erstreckt und erste feste Abschnitte (90) umfasst, die mit dem Substrat (50) starr verbunden sind; die zweite Strukturschicht (54) zweite feste Abschnitte (91) umfasst, die in direktem Kontakt mit den ersten festen Abschnitten (90) stehen; und eine Kappenstruktur (55) starr mit den zweiten festen Abschnitten (91) gekoppelt ist und zusammen mit dem Substrat (50), den ersten festen Abschnitten und den zweiten festen Abschnitten eine Kammer (93) bildet, die das Trägheitselement (35; 36) und das Wake-up-Element (10) umschließt.

4. Trägheits-MEMS-System nach einem der vorhergehenden Ansprüche, wobei die erste und die zweite Strukturschicht (53, 53) aus Silizium bestehen.

5. Trägheits-MEMS-System nach einem der vorhergehenden Ansprüche, wobei die piezoelektrische Struktur (56) einen piezoelektrischen Stapel umfasst, der einen ersten Elektrodenbereich (63) aus einem ersten leitfähigen Material, der über der aufgehängten Struktur (57) liegt; einen piezoelektrischen Bereich (64) aus piezoelektrischem Material, der über dem ersten Elektrodenbereich (63) liegt; und einen zweiten Elektrodenbereich (65) aus einem zweiten leitfähigen Material enthält, der über dem piezoelektrischen Bereich (64) liegt; wobei mindestens einer des ersten und des zweiten Elektrodenbereichs (63, 65) mit externen Verbindungsbereichen (12) gekoppelt ist.

6. Trägheits-MEMS-System nach einem der vorhergehenden Ansprüche, wobei die erste Strukturschicht (53) eine erste Dicke aufweist, die zweite Strukturschicht (54) eine zweite Dicke aufweist, die kleiner als die erste Dicke ist, und die zweite Strukturschicht (54) eine dünne Zone aufweist, die eine dritte Dicke aufweist, die kleiner als die zweite Dicke ist, wobei die dünne Zone die aufgehängte Struktur (57) bildet und sich in einem Abstand von der ersten Strukturschicht (53) erstreckt.

7. Trägheits-MEMS-System nach einem der vorhergehenden Ansprüche, wobei das Trägheitselement (35, 36) einen Beschleunigungsmesser und/oder ein Gyroskop bildet.

8. Trägheits-MEMS-System nach einem der vorhergehenden Ansprüche, wobei das Trägheitselement (35, 36) von dem kapazitiven Typ ist.

9. Trägheits-MEMS-System nach einem der vorhergehenden Ansprüche, wobei das Aktivierungselement ferner eine aufgehängte Masse (60C) umfasst, die integraler Bestandteil der aufgehängten Struktur (57) ist, die durch die erste und die zweite Strukturschicht (53, 54) gebildet wird und seitlich zu dem Trägheitselement (35; 36) angeordnet ist.

10. Trägheits-MEMS-System nach einem der vorhergehenden Ansprüche, das ferner Mittel umfasst, die für Folgendes konfiguriert sind:
nach dem Schritt des Aktivierens der Trägheits-MEMS-Vorrichtung (2) in dem verbrauchsarmen Betrieb, Empfangen elektrischer Messsignale von dem Trägheitselement 35; 36; Überprüfen, ob das Aktivierungssignal (a1) und/oder die elektrischen Messsignale nach einer Erfassungszeit repräsentativ für vorbestimmte Bewegungen sind; und, wenn die Aktivierungssignale (a1) und/oder die elektrischen Messsignale nicht repräsentativ für vorbestimmte Bewegungen sind, Deaktivieren der Trägheits-MEMS-Vorrichtung (2).

11. Verfahren zum Aktivieren einer Trägheits-MEMS-Vorrichtung (2) in dem Trägheits-MEMS-System nach einem der Ansprüche 1 bis 10, umfassend:
Empfangen des Aktivierungssignals (a1);
Vergleichen des Aktivierungssignals (a1) mit einem ersten Schwellenwert (Th1) und einem zweiten Schwellenwert (Th2), der größer als der erste Schwellenwert ist,
Aktivieren der Trägheits-MEMS-Vorrichtung (2) in dem verbrauchsarmen Betrieb, wenn das Aktivierungssignal (a1) größer als der erste Schwellenwert und kleiner als der zweite Schwellenwert ist; und
Aktivieren der Trägheits-MEMS-Vorrichtung (2) in dem verbrauchsintensiven Betrieb, wenn das Aktivierungssignal (a1) größer als der zweite Schwellenwert ist.

12. Verfahren zum Herstellen eines Trägheits-MEMS-Systems nach einem der Ansprüche 1 bis 10, umfassend:
Bilden einer ersten Strukturschicht (53) aus Halbleitermaterial auf einem Substrat (50);
Bilden eines Trägheitselements (35; 36), einschließlich einer beweglichen Struktur (43; 44; 46; 60A), in der ersten Strukturschicht (53);
Bilden einer zweiten Strukturschicht (54) aus Halbleitermaterial auf der ersten Strukturschicht (53);
Bilden einer aufgehängten Struktur (57) in der zweiten Strukturschicht (54), wobei sich die aufgehängte Struktur oberhalb der beweglichen Struktur (43; 44; 46; 60A) in einem Abstand von dieser erstreckt; und
Bilden einer piezoelektrischen Struktur oberhalb der aufgehängten Struktur (57),
wobei die aufgehängte Struktur und die piezoelektrische Struktur ein Wake-up-Element (10) bilden, das so konfiguriert ist, dass es bei Vorhandensein von Vibrationen oder Stößen ein Aktivierungssignal (a1) erzeugt.

13. Verfahren nach dem vorhergehenden Anspruch, wobei das Bilden einer aufgehängten Struktur (57) Folgendes umfasst:
vor dem Bilden einer zweiten Strukturschicht ((54)), Bilden eines Opferbereichs (72) oberhalb der beweglichen Struktur (43; 44; 46; 60A);
nach dem Schritt des Bildens einer piezoelektrischen Struktur (56), Definieren der zweiten Strukturschicht (54); und
Entfernen des Opferbereichs (72).

14. Verfahren nach Anspruch 12 oder 13, ferner umfassend das Befestigen einer Kappenstruktur (55) an der zweiten Strukturschicht (54) sowie das Bilden einer Kammer (93), die das Trägheitselement (35; 36) und das Wake-up-Element (10) umschließt, zusammen mit dem Substrat (50), der ersten Strukturschicht (53) und der zweiten Strukturschicht (54).

## Revendications

1. Système MEMS inertiel (1) comportant un dispositif MEMS inertiel (2), comprenant :
un élément inertiel (35 ; 36) sensible au mouvement, comportant une structure mobile (43 ; 44 ; 46) formée dans une première couche structurale (53) en matériau semi-conducteur ;
une structure suspendue (57) s'étendant au-dessus de la structure mobile, à une certaine distance de celle-ci, la structure suspendue (57) étant formée dans une seconde couche structurale de matériau semi-conducteur ; et
une structure piézoélectrique (56) agencée sur la structure suspendue (57),
la structure suspendue (57) et la structure piézoélectrique (56) formant un élément de réveil (10) configuré pour générer un signal d'activation (a1) en présence de vibrations ou de chocs
le système comprenant en outre une unité de contrôle (3), l'unité de contrôle (3) étant couplée électriquement au dispositif MEMS inertiel (2) et comprenant des moyens configurés pour :
recevoir le signal d'activation (a1) ;
comparer le signal d'activation (a1) à un premier seuil (Th1) et un second seuil (Th2), supérieur au premier seuil, activer le dispositif MEMS inertiel (2) en fonctionnement à faible consommation si le signal d'activation (a1) est supérieur au premier seuil et inférieur au second seuil ; et
activer le dispositif MEMS inertiel (2) en fonctionnement à forte consommation si le signal d'activation (a1) est supérieur au second seuil.

2. Système MEMS inertiel selon la revendication 1, dans lequel la structure suspendue (57) est un porte-à-faux ou une membrane.

3. Système MEMS inertiel selon la revendication 1 ou 2, comprenant en outre un substrat (50) en matériau semi-conducteur, dans lequel la première couche structurale (53) s'étend sur le substrat et comprend des premières parties fixes (90) rigides avec le substrat (50) ; la seconde couche structurale (54) comprend des secondes parties fixes (91) en contact direct avec les premières parties fixes (90) ; et une structure de capuchon (55) est rigidement couplée aux secondes parties fixes (91) et forme, avec le substrat (50), les premières parties fixes et les secondes parties fixes, une chambre (93) renfermant l'élément inertiel (35 ; 36) et l'élément de réveil (10).

4. Système MEMS inertiel selon l'une quelconque des revendications précédentes, dans lequel la première et la seconde couche structurale (53, 53) sont en silicium.

5. Système MEMS inertiel selon l'une quelconque des revendications précédentes, dans lequel la structure piézoélectrique (56) comprend un empilement piézoélectrique comportant une première région d'électrode (63), en premier matériau conducteur, superposée à la structure suspendue (57) ; une région piézoélectrique (64), en matériau piézoélectrique, superposée à la première région d'électrode (63) ; et une seconde région d'électrode (65), en second matériau conducteur, superposée à la région piézoélectrique (64) ; au moins l'une de la première et de la seconde région d'électrode (63, 65) étant couplée à des régions de connexion externes (12).

6. Système MEMS inertiel selon l'une quelconque des revendications précédentes, dans lequel la première couche structurale (53) a une première épaisseur, la seconde couche structurale (54) a une deuxième épaisseur, inférieure à la première épaisseur, et la seconde couche structurale (54) a une zone mince ayant une troisième épaisseur inférieure à la deuxième épaisseur, la zone mince formant la structure suspendue (57) et s'étendant à une certaine distance de la première couche structurale (53).

7. Système MEMS inertiel selon l'une quelconque des revendications précédentes, dans lequel l'élément inertiel (35, 36) forme un accéléromètre et/ou un gyroscope.

8. Système MEMS inertiel selon l'une quelconque des revendications précédentes, dans lequel l'élément inertiel (35, 36) est de type capacitif.

9. Système MEMS inertiel selon l'une quelconque des revendications précédentes, dans lequel l'élément d'activation comprend en outre une masse suspendue (60C), solidaire de la structure suspendue (57), formée par les première et seconde couches structurales (53, 54) et agencée latéralement à l'élément inertiel (35 ; 36).

10. Système MEMS inertiel selon l'une quelconque des revendications précédentes, comprenant en outre des moyens configurés pour :
après l'étape d'activation du dispositif MEMS inertiel (2) en fonctionnement à faible consommation, recevoir des signaux de mesure électriques de l'élément inertiel (35 ; 36) ; vérifier si, après un temps d'acquisition, le signal d'activation (a1) et/ou les signaux de mesure électriques sont représentatifs de mouvements prédéterminés ; et, si les signaux d'activation (a1) et/ou les signaux de mesure électriques ne sont pas représentatifs de mouvements prédéterminés, désactiver le dispositif MEMS inertiel (2).

11. Procédé pour activer un dispositif MEMS inertiel (2) dans le système MEMS inertiel selon l'une quelconque des revendications 1-10, comprenant :
la réception du signal d'activation (a1) ;
la comparaison du signal d'activation (a1) à un premier seuil (Th1) et un second seuil (Th2), supérieur au premier seuil,
l'activation du dispositif MEMS inertiel (2) avec un fonctionnement à faible consommation si le signal d'activation (a1) est supérieur au premier seuil et inférieur au second seuil ; et
l'activation du dispositif MEMS inertiel (2) en fonctionnement à forte consommation si le signal d'activation (a1) dépasse le second seuil.

12. Processus pour fabriquer un système MEMS inertiel selon l'une quelconque des revendications 1-10, comprenant :
la formation d'une première couche structurale (53) en matériau semi-conducteur sur un substrat (50) ;
la formation d'un élément inertiel (35 ; 36), comportant une structure mobile (43 ; 44 ; 46 ; 60A), dans la première couche structurale (53) ;
la formation d'une seconde couche structurale (54) de matériau semi-conducteur sur la première couche structurale (53) ;
la formation d'une structure suspendue (57) dans la seconde couche structurale (54), la structure suspendue s'étendant au-dessus de la structure mobile (43 ; 44 ; 46 ; 60A), à une certaine distance de celle-ci ; et
la formation d'une structure piézoélectrique au-dessus de la structure suspendue (57),
la structure suspendue et la structure piézoélectrique formant un élément de réveil (10) configuré pour générer un signal d'activation (a1) en présence de vibrations ou de chocs.

13. Processus selon la revendication précédente, dans lequel la formation d'une structure suspendue (57) comprend :
avant la formation d'une seconde couche structurale (54), la formation d'une région sacrificielle (72) au-dessus de la structure mobile (43 ; 44 ; 46 ; 60A) ;
après l'étape de formation d'une structure piézoélectrique (56), la définition de la seconde couche structurale (54) ; et
le retrait de la région sacrificielle (72).

14. Processus selon la revendication 12 ou 13, comprenant en outre la fixation d'une structure de capuchon (55) à la seconde couche structurale (54) et la formation, avec le substrat (50), la première couche structurale (53) et la seconde couche structurale (54), d'une chambre (93) enfermant l'élément inertiel (35 ; 36) et l'élément de réveil (10).
